# EUROPÄISCHE PATENTSCHRIFT

(11) **EP 0 933 445 B1**
(45) Veröffentlichungstag und Bekanntmachung des Hinweises auf die Patenterteilung: **09.04.2003**
(21) Anmeldenummer: 99100905.1
(22) Anmeldetag: 20.01.1999
(51) Int. Cl.: C23C 16/44, C23C 10/06, C23C 16/40

(54) **Verfahren und Vorrichtung zur Gasphasenbeschichtung von Werkstücken**
Method and apparatus for CVD coating of workpieces
Procédé et dispositif pour le revêtement de pieces par dépôt chimique en phase vapeur

(30) Priorität: 30.01.1998 DE 19803740
(43) Veröffentlichungstag der Anmeldung: 04.08.1999
(73) Patentinhaber: MTU Aero Engines GmbH, 80995 München (DE)
(72) Erfinder: Walter, Heinrich, 86316 Friedberg (DE)
(74) Vertreter: Einsele, Rolf W.

(56) Entgegenhaltungen:
- DE-B- 1 265 530
- US-A- 2 650 564
- PATENT ABSTRACTS OF JAPAN vol. 011, no. 381 (C-464), 12. Dezember 1987 & JP 62 149883 A (HITACHI CHEM CO LTD), 3. Juli 1987
- GARCIA G ET AL: "PREPARATION OF YSZ LAYERS BY MOCVD: INFLUENCE OF EXPERIMENTAL PARAMETERS ON THE MORPHOLOGY OF THE FILMS" JOURNAL OF CRYSTAL GROWTH, Bd. 156, Nr. 4, 1. Dezember 1995, Seiten 426-432, XP004000432

## Beschreibung

Die vorliegende Erfindung betrifft ein Gasphasenbeschichtungsverfahren, bei dem ein oder mehrere zu beschichtende Werkstücke in einem Behälter angeordnet werden, der Behälter geheizt wird und ein Spenderstoff mit einem Aktivator durch Aufheizen ein Beschichtungsgas bildet, das im Behälter mit den Werkstücken in Kontakt gebracht und während des Beschichtungsvorgangs zumindest zeitweise im Behälter umgewälzt wird sowie eine Vorrichtung zur Gasphasenbeschichtung von Werkstücken.

Bei bekannten Vorrichtungen und Verfahren zur Gasphasenbeschichtung von Werkstücken, beispielsweise Turbinenschaufeln, werden diese beispielsweise im oberen Bereich eines Behälters angeordnet. Im unteren Bereich weist der Behälter eine Trägergaszuleitung und ein Tragegitter zur Aufnahme eines Spendermetallgranulats und eines Aktivatorpulvers auf. Der Behälter wird eine bestimmte Zeit unter Argon oder H₂ geglüht und im Behälter bildet sich in der Nähe des Spendermetallgranulats ein Spendermetallgas aus.

Dabei tritt das Problem auf, dass die sich bildenden schweren Spendermetallgase vom Spendermetallgranulat zu den zu beschichtenden Bauteilen aufsteigen müssen, wobei entsprechend der barometrischen Höhenformel eine Verdünnung der Spendermetallgase in vertikaler Richtung auftritt, die zu unterschiedlichen Schichtdicken auf den Bauteilen in Abhängigkeit von ihrer geodätischen Höhe bezüglich des Spendermetalls führen. Insbesondere bei Behältern mit großen Nutzräumen entsteht ein großer Schichtgradient von unten nach oben in barometrischer Abhängigkeit aufgrund der Schwere des Beschichtungsgases. Dabei ist es unwesentlich, ob das Spendermetall am Boden des Behälters und/oder unterhalb des Deckels des Behälters bzw. Reaktors verteilt ist, oder ob ein schmelzflüssiges Spendermetall verwendet wird. Darüber hinaus tritt bei der Beschichtung von Innenflächen hohler Bauteile das Problem auf, dass die Beschichtungsdicke abnimmt, je weiter die zu beschichtende Fläche im Inneren des Bauteils liegt.

Mit einer in den Reaktor geführten Gasspülleitung wurde versucht, die Gasqualität zu steuern und bis zu einem gewissen Grad zu verbessern. Jedoch funktioniert diese Anordnung mit hinreichend geringem Schichtgradienten nur bei Nutzräumen mit geringer Höhe. Insbesondere bei Nutzraumhöhen von ca. 120 mm und mehr entsteht ein nachteilhafter Schichtgradient, d.h. das beschichtete Bauteil hat unterschiedliche Beschichtungsdicken in Abhängigkeit von der jeweiligen Höhe im Reaktor während der Beschichtung.

WO 92/08821 zeigt eine Vorrichtung zum Gasdiffusionsbeschichten von hohlen Werkstücken mit einem Behälter, der eine Gaszuleitung und eine Gasableitung aufweist, wobei die Gasableitung den zu beschichtenden Innenflächen des Werkstücks nachgeschaltet ist. Bei diesem Verfahren werden die Werkstücke in geodätisch geringer Höhe bezüglich des Spendermetalls gehalten, wobei das Spendermetall in Form eines Spendermetallkörpers vorliegt, der unter Einhaltung eines Spaltes die zu beschichtenden Außenflächen des Werkstücks vollständig umhüllt. Ein von oben in den Behälter geführtes Trägergas wird an einer Spendermetallkörperanordnung vorbeigeführt, die oberhalb des zu beschichtenden Bauteils und um das Bauteil herum angeordnet ist. Anschließend wird das Beschichtungsgas durch das Innere des Bauteils geführt und an der Unterseite des Behälters abgeleitet. Um eine hohe Spendermetallkonzentration im Bereich des Bauteils zu gewährleisten, ist die Gasableitung als Überlauf bzw. Syphon geformt, so dass sich im Bereich des Bauteils ein Spendermetallgassumpf ausbildet. Jedoch erfordert diese bekannte Vorrichtung eine aufwendige Anordnung und Ausgestaltung des Spendermetallkörpers, der darüber hinaus exakt zum Bauteil ausgerichtet und an dessen Form angepasst sein muß. Eine Beschichtung verschiedenartiger Bauteile mit unterschiedlichen Geometrien erfordert jeweils unterschiedliche Spendermetallkörper, was aufwendig und kostenintensiv ist und zu einer geringen Flexibilität führt. Darüber hinaus ist auch bei einer Syphonanordnung eine barometrische Abhängigkeit der Spendermetallgaskonzentration vorhanden.

Aus der DE-B-12 65 530 ist eine Vorrichtung zum Gasplattieren einer Metallbandspule bekannt, bei der das Beschichtungsgas mittels eines Ventilators oder Gebläses (5) umgewälzt wird. Dabei ist das Gebläserad direkt den heißen Beschichtungsgasen ausgesetzt. Für die Zu- und Abfuhr der Gasatmosphäre im Vorrichtungsinneren sind Zuleitungen (30) und Ableitungen (29) vorhanden, die am Umfang der Vorrichtung im Bodenbereich münden. Im Betrieb wird zunächst die Luft im Vorrichtungsinneren i.w. durch Stickstoff verdrängt, beim Übergang zu sehr hohen Temperaturen wird der Stickstoff durch Wasserstoff ersetzt. Das Abkühlen nach dem Beschichten erfolgt wieder i.w. mit Stickstoff. Beim Öffnen der Vorrichtung zum Austausch der Spule dringt wieder Umgebungsluft in das Vorrichtungsinnere ein.

Es ist daher die Aufgabe der vorliegenden Erfindung, die o.g. Probleme zu überwinden und ein Gasphasenbeschichtungsverfahren und eine Vorrichtung zur Gasphasenbeschichtung zu schaffen, mit dem bzw. mit der bei geringem Aufwand und hoher Flexibilität eine gleichmäßigere Beschichtung von Außen- und Innenflächen des Bauteils im gesamten Nutzraum des Reaktors erzielt werden kann.

Diese Aufgabe wird durch das Gasphasenbeschichtungsverfahren gemäß dem Patentanspruch1 und durch die Vorrichtung zur Gasphasenbeschichtung gemäß dem unabhängigen Patentanspruch 6 gelöst. Weitere vorteilhafte Merkmale, Aspekte und Details der Erfindung ergeben sich aus den abhängigen Ansprüchen, der Beschreibung und den Zeichnungen.

Bei dem erfindungsgemäßen Gasphasenbeschichtungsverfahren werden ein oder mehrere zu beschichtende Werkstücke, ein Spenderstoff und ein Aktivator in einem Behälter angeordnet und der Behälter wird geheizt, wobei der Spenderstoff ein Beschichtungsgas bildet, das mit dem Werkstück in Kontakt gerät, und wobei das Beschichtungsgas während des Beschichtungsvorgangs zumindest zeitweise im Behälter umgewälzt wird. Durch die Umwälzung wird eine gleichmäßige Beschichtungsgaskonzentration im Behälter erreicht, so dass die Ausbildung eines Schichtgradienten vermieden wird.

Dabei wird ein Treibgas, das insbesondere ein inertes Treibgas, wie z.B. Ar, He, Kr, Ne sein kann, durch eine im Behälter angeordnete Venturidüse in den Behälter geleitet. Dadurch wird auf besonders rationelle und kostengünstige Weise eine Umwälzung des Beschichtungsgases erreicht, wobei die Verdünnung des Beschichtungsgases gering gehalten wird. Durch die Vermeidung beweglicher Bauteile kann eine Umwälzung auch bei sehr hohen Temperaturen erfolgen. Es ist auch H₂ als Treibgas möglich, z. B. um die Bildung von HF oder HCI beim Beschichtungsprozess zu bewirken.

Vorteilhafterweise wird im Behälter befindliches Treibgas im oberen Bereich des Behälters durch Gravitation vom Beschichtungsgas getrennt und nach oben aus dem Behälter abgeführt, während das schwerere Beschichtungsgas im Behälter verbleibt. Dadurch wird eine hohe Beschichtungsgaskonzentration bei der Umwälzung erreicht.

Bevorzugt ist die Venturidüse im unteren Bereich des Behälters so angeordnet, dass das Beschichtungsgas und/oder das Treibgas vertikal zirkuliert.

Es können auch keramische Schichten auf das Werkstück aufgebracht werden, wobei als Spenderstoff vorzugsweise Zr(tmhd)₄ und/oder Y(tmhd)₃ verwendet wird. Dabei kann das Beschichtungsverfahren auch bei niedrigen Prozesstemperaturen ablaufen.

Die erfindungsgemäße Vorrichtung zur Gasphasenbeschichtung von Werkstücken umfasst einen Behälter zur Aufnahme von einem oder mehreren zu beschichtenden Werkstücken, eine Einrichtung zur Bereitstellung eines Spenderstoffs und eines Aktivators, eine Heizvorrichtung zum Heizen des Behälters und Mittel zur Umwälzung des Beschichtungsgases im Behälter, so dass beim Beschichten das Beschichtungsgas im Behälter zirkuliert.

Dabei ist zur Umwälzung eine Venturidüse an einem Ende eines von außen zugeführten Treibgasrohres angeordnet. Bevorzugt ist die Venturidüse derart angeordnet, dass das vom Treibgas umgewälzte Beschichtungsgas in einem zentralen Bereich des Behälters nach oben strömt, während es im Behälter zirkuliert.

Das erfindungsgemäße Gasphasenbeschichtungsverfahren und die erfindungsgemäße Vorrichtung zur Gasphasenbeschichtung werden nachfolgend anhand der Zeichnungen beispielhaft beschrieben, wobei in
- Fig. 1: eine Beschichtungsvorrichtung gemäß einer bevorzugten Ausführungsform der Erfindung,
- Fig. 2: eine Beschichtungsvorrichtung gemäß einer weiteren Ausführungsform der Erfindung,
- Fig. 3: eine Beschichtungsvorrichtung gemäß einer noch weiteren Ausführungsform der Erfindung,
- Fig. 4: eine Beschichtungsvorrichtung zum Alitieren mit einer Aluminiumschmelze als Spender,
- Fig. 5: eine Beschichtungsvorrichtung zum Chromieren von Gehäuseteilen mit Gasumwälzung
schematisch dargestellt ist.

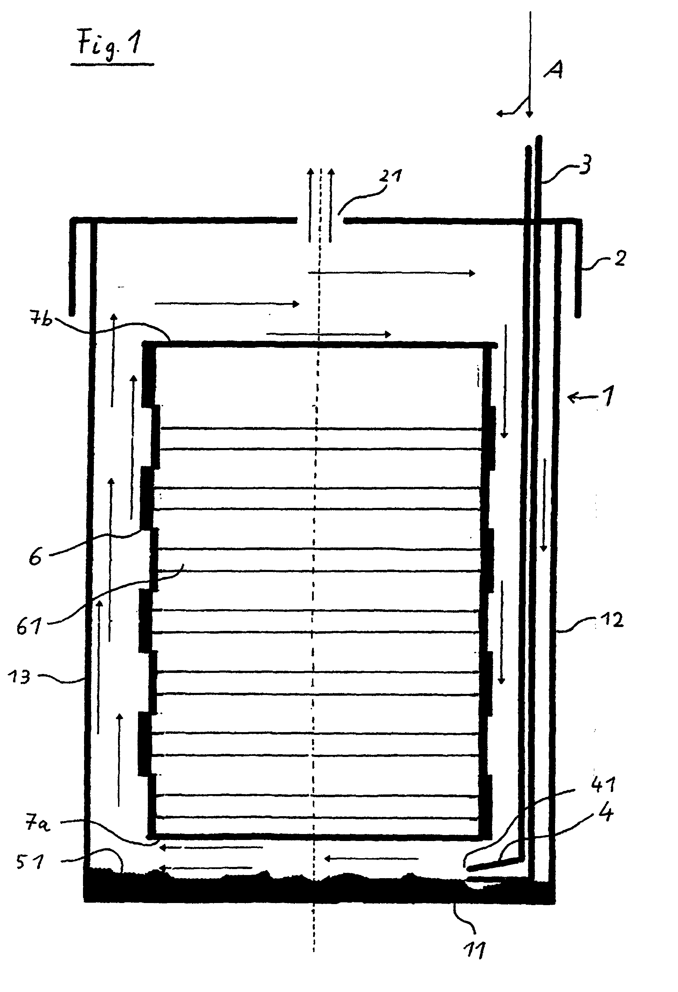

Fig. 1 zeigt eine Vorrichtung zum Beschichten von Werkstücken, die eine bevorzugte Ausführungsform der Erfindung ist. Die Beschichtungsvorrichtung weist einen Behälter 1 auf, der durch einen lose aufliegenden Deckel 2 von oben verschlossen ist. Ein Treibgasrohr 3 ist von oben durch den Deckel 2 in den Innenraum des Behälters 1 geführt und mündet im unteren Bereich des Behälters knapp oberhalb des Behälterbodens 11. Dabei verläuft das Treibgasrohr 3 im Randbereich des Behälters 1 senkrecht von oben nach unten, parallel zu einer Seitenwand 12 des Behälters 1. Am Ende des Treibgasrohres 3 ist eine Venturidüse 4 angeordnet, deren Düsenöffnung 41 von der Seitenwand 12 weg weist, so dass durch die Düsenöffnung 41 ausströmendes Gas parallel zum Behälterboden 11 strömt, wie durch die Pfeile gezeigt. Auf dem Boden des Behälters liegt ein Cromgranulat 51, das mit pulverförmigem NH₄Cl vermischt ist, das als Aktivator dient. Der Behälterboden 11 ist mit dem Chromgranulat 51 und dem Aktivator bedeckt und darüber ist die Venturidüse 4 in der Nähe der Seitenwand 12 des Behälters 1 so angeordnet, dass durch die Venturidüse 4 ausströmendes Treibgas das Chromgranulat 51 und den Aktivator überstreicht.

In einem zentralen Bereich des Behälters 1 ist eine Haltevorrichtung 6 zum Halten bzw. Tragen mehrerer zu beschichtender Werkstücke 61, im vorliegenden Fall Turbinenschaufeln, angeordnet.

Beim Beschichten werden die Werkstücke in verschiedenen Ebenen bzw. Niveaus im Behälter 1 gehalten, wobei annähernd der gesamte Innenraum des Behälters 1 ausgenutzt wird. Dabei sind die Werkstücke bzw. Turbinenschaufeln 61 parallel zueinander in horizontaler Ausrichtung in der Haltevorrichtung 6 gelagert. Die Haltevorrichtung 6 ist in Form eines Gerüsts ausgebildet, so dass sie an ihren Seiten offen ist (in der Figur nicht dargestellt), um einen möglichst freien Zugang des Beschichtungsgases zu den Schaufeloberflächen zu gewährleisten. Am unteren und am oberen Ende der Haltevorrichtung 6 befindet sich jeweils ein Leitblech 7a, 7b, das als ebene Platte bzw. Scheibe ausgebildet ist und parallel zum Behälterboden 11 bzw. zum Behälterdeckel 2 in horizontaler Ausrichtung angeordnet ist. In den Leitblechen 7a, 7b sind in der Figur nicht dargestellte Löcher angeordnet, so dass Beschichtungsgas durch die Leitbleche 7a, 7b in vertikaler Richtung hindurchströmen kann. Die Leitbleche 7a, 7b dienen als Verteilerblenden, um den Gasstrom im oberen und im unteren Bereich des Behälters 1 parallel zum Behälterboden 11 bzw. Behälterdeckel 2, d. h. in horizontaler Richtung, zu leiten und gleichmäßig über das auf dem Behälterboden 1 liegende Chromgranulat 51 und den Aktivator zu verteilen. In der Mitte des Behälterdeckels 2 befindet sich eine Abgasöffnung 21 zur Ableitung des Treibgases.

Das erfindungsgemäße Beschichtungsverfahren wird nachfolgend anhand des Chromierens von Turbinenschaufeln als Werkstücke 61 beschrieben. Nachdem die Werkstücke 61 1 wie oben ausgeführt in der Haltevorrichtung 6 innerhalb des Behälters 1 angeordnet wurden, wird Argon als Treibgas durch das Treibgasrohr 3 in den Behälter 1 eingeleitet, wie durch Pfeil A gekennzeichnet, wobei der Behälter 1 in einer nicht dargestellten Ofenretorte bzw. Heizvorrichtung steht und auf eine Temperatur von ca. 1100°C aufgeheizt wird. Das Argon durchströmt das Treibgasrohr 3 und die an seinem Ende angeordnete Venturidüse 4. Beim Durchlaufen des Treibgasrohres 3 wird das Argon aufgeheizt und erfährt eine thermisch bedingte Expansion bzw. Druckerhöhung im Endbereich des Treibgasrohres 3. Nach dem Austritt aus der Düsenöffnung 41 strömt das Argon in horizontaler Richtung parallel zur Oberfläche des Chromgranulats 51 und des Aktivators zwischen dem Behälterboden 11 und dem unteren Leitblech 7a. Über dem Chromgranulat 51 entsteht gasförmiges Chromchlorid als Beschichtungsgas. Das Beschichtungsgas wird zusammen mit dem Treibgas an der der Venturidüse 4 gegenüberliegenden Seitenwand 13 des Behälters 1 parallel zu dieser vertikal nach oben geleitet und im oberen Bereich des Behälters 1 zwischen dem oberen Leitblech 7b und dem Behälterdeckel 2 horizontal auf die gegenüberliegende Seite zur Seitenwand 12 geleitet. Da das Beschichtungsgas schwerer ist als das Treibgas, erfolgt im oberen Bereich des Behälters 1 eine Trennung bzw. Separierung des Treibgases vom Beschichtungsgas, so dass das leichtere Treibgas aus der Abgasöffnung 21 nach oben entweichen kann. Das schwerere Chromchlorid strömt durch die im Leitblech 7b befindlichen Löcher und im Bereich des Treibgasrohres 3 entlang der Seitenwand 12 nach unten, so dass es mit den Oberflächen der Turbinenschaufeln in Kontakt gerät. Dabei diffundiert das Chrom in die Werkstück- bzw. Schaufeloberflächen ein, wobei durch die Umwälzung auch im Innenraum der Schaufeln befindliche Hohlräume gleichmäßig mit dem Beschichtungsgas in Kontakt geraten. Nachdem das Chromchloridgas die Schaufelanordnung von oben nach unten passiert hat wird es erneut über das Chromgranulat 51 und den Aktivator geleitet und nimmt wiederholt an dem Gaskreislauf im Behälter 1 teil. Dabei wird erneut Argon durch das Treibgasrohr 3 dem Behälterinnenraum zugeführt und die Umwälzung bzw. der Kreislauf des Beschichtungsgases wird durch die Anordnung der Venturidüse 4 bzw. durch das Treibgas angetrieben. Die Strömungsrichtung des im Behälter 1 zirkulierenden Gasstromes ist durch die Pfeile gekennzeichnet. In der vorliegenden Ausführungsform hat der Reaktorbehälter 1 einen Durchmesser von 500 mm und eine Höhe von 810 mm.

Bei dem Verfahren kann durch das Treibgasrohr 3 zusätzlich HCI zugegeben werden, wodurch der Beschichtungsprozess auch über einen sehr langen Zeitraum stabil gehalten wird, da ein Verlustausgleich für evtl. dem Kreislauf entnommenes Cl stattfindet. In diesem Fall ist das Treibgasrohr 3 aus Keramik gefertigt, um nicht durch das HCI beschädigt zu werden.

In einem weiteren Ausführungsbeispiel, das hier nicht dargestellt ist, wird das durch die Abgasöffnung 21 entweichende Treibgas außerhalb des Behälters umgepumpt und dem Behälter über das Treibgasrohr 3 wieder zugeführt.

Das Verfahren wird bevorzugt so durchgeführt, dass in bestimmten Zeitabständen, vorzugsweise alle 10 Minuten, während einer Dauer von ca. 10 sek. Treibgas eingepumpt wird, wobei im vorliegenden Fall die Umwälzung während der Treibgaszufuhr mit einem Treibgasdurchsatz von ca. 800 - 1000 I pro Stunde durchgeführt wird. Durch die pulsartige Treibgaszufuhr wird die Verdünnung des Beschichtungsgases gering gehalten und es werden vorteilhafte Strömungsbedingungen zur Diffusionsbeschichtung bei einer gleichmäßigen Verteilung des Beschichtungsgases im gesamten Innenraum des Behälters 1 erreicht. Durch die Strömung an der Venturidüse 4 wird das Treibgas umgewälzt, ohne dass mechanisch bewegliche Bauteile verwendet werden. Dies ist insbesondere bei sehr hohen Temperaturen vorteilhaft, da keine Beschädigungen von Lagern bzw. Dreh- und Schiebedurchführungen durch Retorte und Reaktor bzw. Behälter 1, z. B. aufgrund der Wärmeausdehnung, auftreten kann. Auch sind keine teuren Antriebs- und Steuerungsvorrichtungen notwendig, die zudem anfällig gegenüber Störungen sind. Durch das Leiten des Beschichtungsgases mittels der Venturidüse 4 über das obere Leitblech 7b kann eine gleichmäßigere Beschichtung in kürzerer Zeit erfolgen, da das Argon durch die Abgasöffnung entweicht und das schwerere Beschichtungsgas von oben an den zu beschichtenden Bauteilen vorbei wieder nach unten fällt.

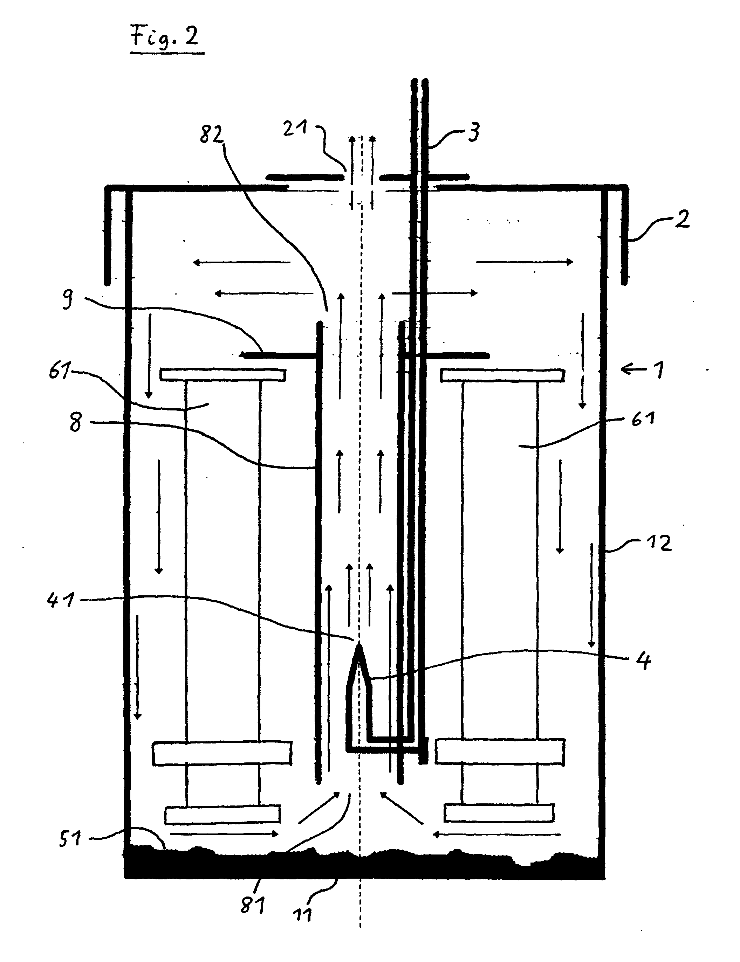

Fig. 2 zeigt eine weitere Ausführungsform der erfindungsgemäßen Beschichtungsvorrichtung, die zum Chromieren von Turbinenschaufeln verwendet wird. In den Figuren sind gleiche oder ähnliche Bauteile mit denselben Bezugszahlen versehen. Dabei ist die am Ende des Treibgasrohres 3 angeordnete Venturidüse 4 so ausgerichtet, dass ihre Düsenöffnung 41 nach oben in Richtung der Abgasöffnung 21 weist. Die Venturidüse 4 befindet sich in der Mitte zwischen den Seitenwänden 12 des zylindrischen Behälters 1 und ist im unteren Bereich des Behälters 1 angeordnet. In der Mitte des Behälters 1 befindet sich ein rohrförmiger Kanal 8, mit einer unteren Öffnung 81 und einer oberen Öffnung 82, der sich in vertikaler Richtung vom unteren Bereich des Behälters 1 nach oben hin erstreckt, wobei sein Durchmesser ca. 1/5 bis 1/6 des Behälterdurchmessers ist. Die Venturidüse 4 befindet sich innerhalb des Kanals 8 in seinem unteren Bereich, wobei die Düsenöffnung 41 in Längsrichtung des Kanals zu seinem oberen Ende hin weist. An der Außenseite der Kanalwandung im oberen Bereich des Kanals ist eine ringförmige, flache Verteilblende 9 angeordnet, die horizontal ausgerichtet ist und sich zum Teil über die vertikal im Behälter 1 angeordneten Turbinenschaufeln 61 erstreckt. Der Behälter 1 hat einen Durchmesser von 500 mm und eine Höhe von 810 mm und an seinem Boden 11 befindet sich das Chromgranulat 51 mit dem Aktivator. Mehrere Turbinenschaufeln 61 sind parallel zueinander ausgerichtet und um die Mittelachse A des Behälters 1 bzw. den dort befindlichen Kanal 8 herum angeordnet.

Beim Umwälzen wird Argon durch das Treibgasrohr 3 in den Behälter 1 geführt und entweicht durch die Düsenöffnung 41 der Venturidüse 4 innerhalb des Kanals 8 nach oben, so dass es in den Kanal 8 vertikal nach oben strömt. Durch die Wirkung der Venturidüse 4 wird an der unteren Öffnung 81 des Kanals 8 Beschichtungsgas in den Kanal 8 eingesaugt und zusammen mit dem Treibgas im Kanal 8 zur oberen Kanalöffnung 82 geleitet. Im oberen Bereich des Behälters 1 trennt sich das leichtere Treibgas vom schwereren Beschichtungsgas und entweicht über die Abgasöffnung 21. Das schwerere Beschichtungsgas wird zwischen dem Reaktordeckel 2 und der Verteilerblende 9 radial nach außen zur Wandung 12 des Behälters 1 geführt und fällt in den zwischen der Wandung des Kanals 8 und der Seitenwand 12 gelegenen Bereichen des Behälters 1 nach unten, wobei es die Turbinenschaufeln 61 umströmt. In der Nähe des Bodens 11 des Behälters 1 trifft das Gas wiederum auf das Chromgranulat 51, dessen Oberfläche es in horizontaler Richtung radial nach innen überstreicht, um dann erneut in den Kanal 8 an seiner unteren Öffnung 81 einzutreten. Das Chromieren der Turbinenschaufeln wird auf diese Weise bei ca. 1220°C durchgeführt. Durch die senkrechte Anordnung der Turbinenschaufeln und die senkrechte bzw. vertikale Gaszirkulation können insbesondere hohle Räume im inneren der Turbinenschaufeln 61, die sich in deren Längsrichtung erstrecken, gleichmäßig und mit konstanter Schichtdicke beschichtet werden.

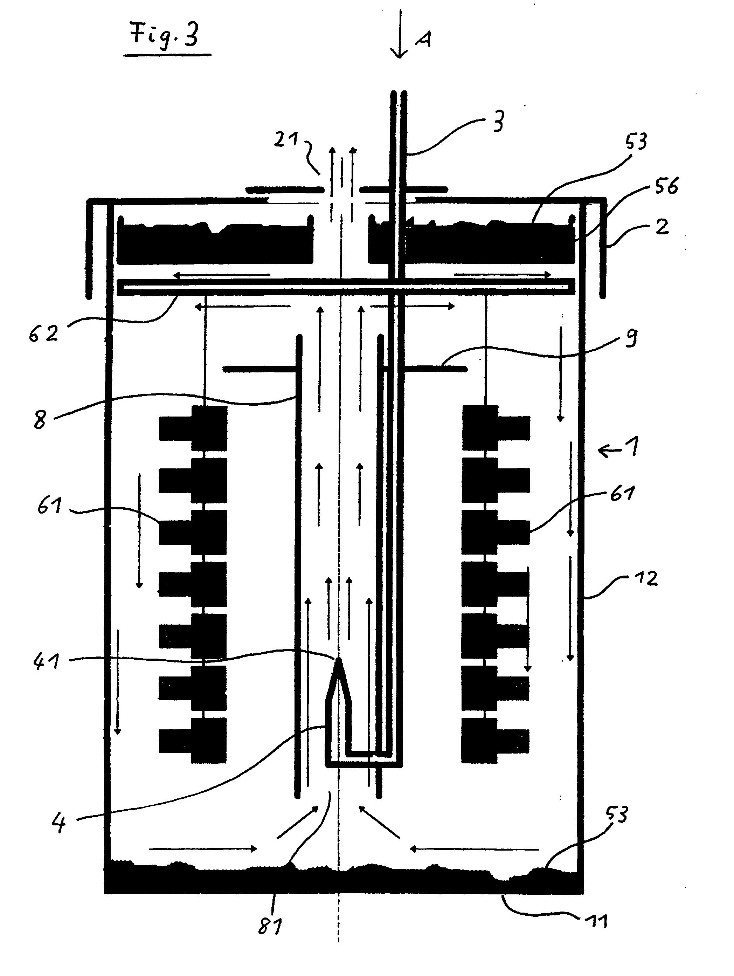

Fig. 3 zeigt schematisch eine noch weitere bevorzugte Ausführungsform der erfindungsgemäßen Beschichtungsvorrichtung, die in diesem Fall zum Alitieren von Laufschaufeln verwendet wird. Dazu befindet sich ein CA50-Granulat 53 zusammen mit einem Aktivator auf dem Behälterboden 11 auf der Innenseite des Behälters 1. Im oberen Bereich des Behälters 1, knapp unterhalb des Behälterdeckels 2, ist ebenfalls CA50-Granulat 53 in korbartigen Spenderstoffbehältern 56 angeordnet. Das Treibgasrohr 3, die Venturidüse 4, und der Kanal 8 mit der Verteilerblende 9 sind wie in der in Fig. 2 beschriebenen Ausführungsform angeordnet. In dem Ringraum zwischen der Wandung des Kanals 8 und der Seitenwand 12 des zylinderförmigen Behälters 1 sind eine Vielzahl von Turbinenschaufeln 61 übereinander in verschiedenen Höhen bzw. Niveaus des Behälters 1 horizontal angeordnet. Die Schaufelanordnung wird durch einen Chargierrahmen 62 im Behälter 1 gehalten.

Beim Beschichten strömt das Beschichtungsgas von dem Granulat 53 im oberen Bereich des Behälters nach unten, wobei es an den Turbinenschaufeln 61 vorbeiströmt. Wie bei der in Fig. 2 gezeigten Ausführungsform wird zum Umwälzen des Beschichtungsgases Treibgas in Form von Argon durch das Treibgasrohr 3 und die Venturidüse 4 geleitet, und durchströmt den Innenraum des Kanals 8 nach oben, wobei es jedoch im oberen Bereich des Behälters 1 auf das dort befindliche Spendergranulat 53 trifft. Auch hier tritt eine Separierung des leichten Treibgases vom schweren Beschichtungsgas auf, wobei das Treibgas durch die Abgasöffnung 21 nach oben entweicht, während das schwerere Beschichtungsgas entlang den Turbinenschaufeln 61 nach unten fällt, wo es erneut auf das auf dem Behälterboden 11 liegende CA50-Granulat 53 und den Aktivator trifft. Anschließend strömt das Beschichtungsgas radial nach innen und tritt erneut in die unten gelegene Öffnung 81 des Kanals 8 ein.

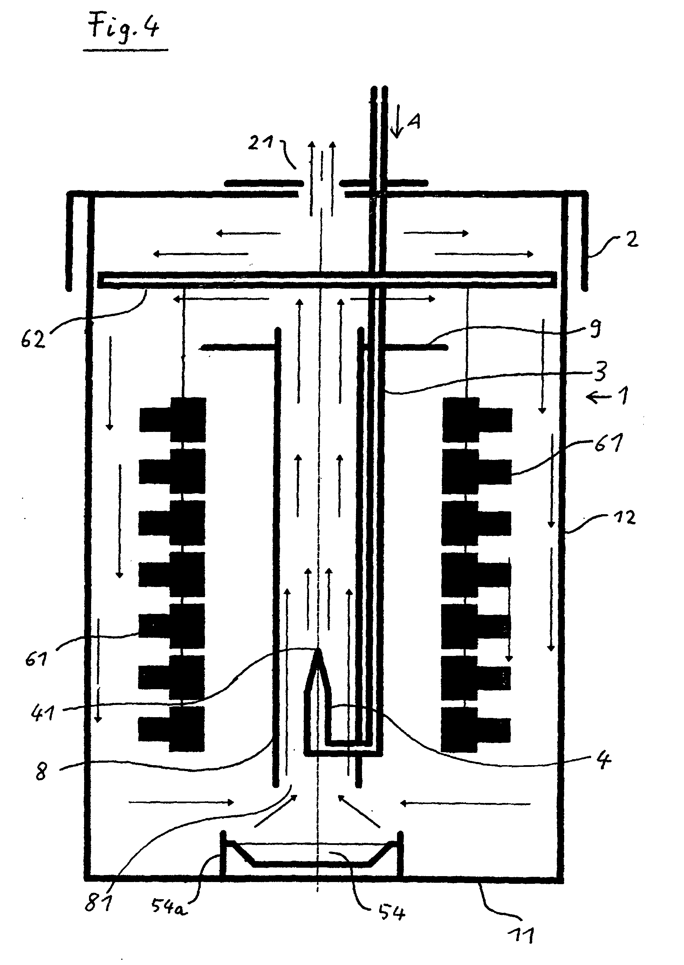

Fig. 4 zeigt schematisch eine erfindungsgemäße Beschichtungsvorrichtung zum Alitieren, wobei hier eine Aluminiumschmelze 54 als Spenderstoff verwendet wird. Die Gasströmung im Behälter ist wie bei den vorhergehenden Figuren durch die Pfeile gekennzeichnet. Der Aufbau ist ähnlich wie bei der in Fig. 3 gezeigten Ausführungsform, jedoch ist anstelle des Granulats die Aluminiumschmelze 54 zusammen mit einem Aktivator im Innenraum des Behälters 1 an seinem Boden 11 angeordnet. Die Aluminiumschmelze 54 und der Aktivator befinden sich in einem Spenderstoffbehälter 54a, der eine kreisförmige Umwandung hat und unterhalb der Öffnung 81 des Kanals 8 angeordnet ist.

Durch eine pulsartige Beschickung der Beschichtungsvorrichtung mit Argon, die alle 10 Minuten während einer Dauer von ca. 10 Sekunden erfolgt, wobei ein Durchsatz von ca. 1000 I pro Stunde während der Beschickung bzw. des Einströmens erfolgt, wird das Treibgas zusammen mit dem Beschichtungsgas im Inneren des Kanals 8 nach oben in den oberen Bereich des Behälters 1 geleitet, wo sich das leichtere Treibgas vom schwereren Beschichtungsgas trennt. Im oberen Bereich des Behälters 1 strömt das Beschichtungsgas parallel zum Chargierrahmen 62 radial von der Mitte des Behälters 1 nach außen zu seinen Seitenwänden 12 und fällt dort nach unten, vorbei an den Turbinenschaufeln 61. Am Behälterboden 11 trifft der Gasstrom auf die Aluminiumschmelze 54 mit dem Aktivator, wodurch er erneut Aluminium aufnimmt, das bei der nächsten Zirkulation an den Oberflächen der Turbinenschaufeln 61 abgelagert wird. Das Verfahren wird bei 1100°C bis ca. 1230°C durchgeführt, wobei auch hierdurch eine Umwälzung des Beschichtungsgases ein Schichtgradient und damit unterschiedliche Schichtdicken vermieden werden, ohne dass mechanisch bewegte Bauteile, Lager, Dichtungen u.ä. verwendet werden müssen.

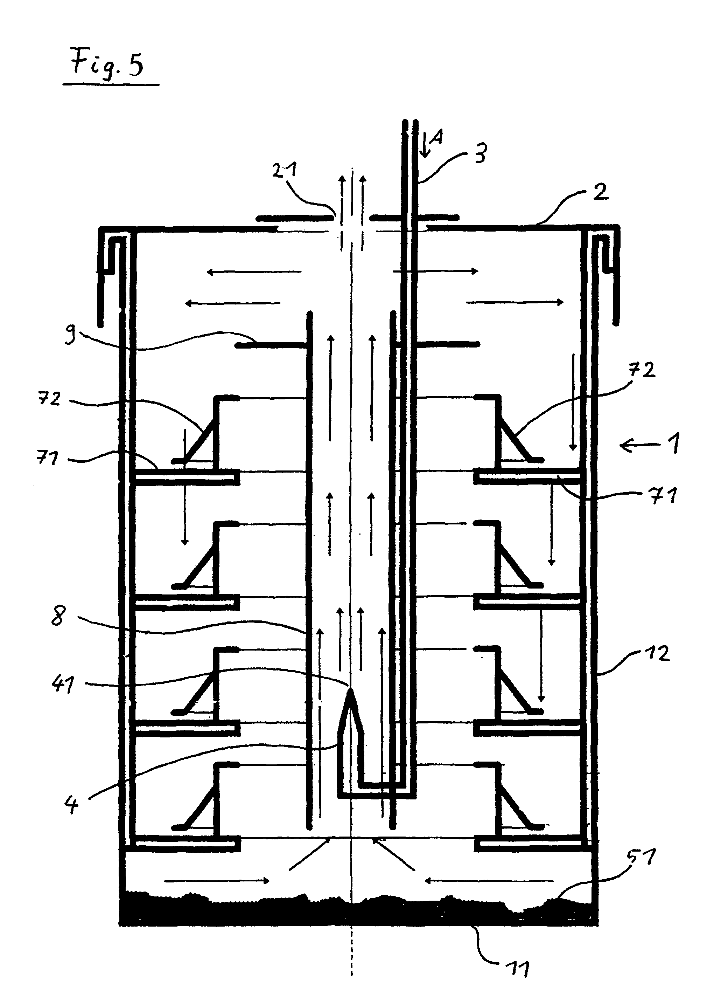

Fig. 5 zeigt noch eine weitere erfindungsgemäße Beschichtungsvorrichtung, die zum Chromieren von Gehäuseteilen verwendet wird. Dabei ist der Behälter 1 mit dem Treibgasrohr 3, der Venturidüse 4 einschließlich der Düsenöffnung 41 und dem Kanal 8 mit der Verteilerblende 9 ähnlich im Behälter angeordnet, wie bei der in Fig. 2 gezeigten Ausführungsform der Erfindung. Am Boden 11 des Behälters 1 befindet sich ebenfalls ein Chromgranulat 51 mit einem Aktivator. Auf der Innenseite der Seitenwand 12 des zylinderförmigen Behälters 1 sind Auflagevorrichtungen 71 in verschiedenen Höhen des Innen- bzw. Nutzraums des Behälters 1 angeordnet. Darauf lagern jeweils zu beschichtende Gehäuseringe 72 (In 909, HDV Stufe 5).

Beim Umwälzen strömt das von oben zugeführte Treibgas Argon aus der Düsenöffnung 41 aus und steigt in dem Kanal 8 im Zentrum des Behälters 1 nach oben, und wird dort aufgrund seines geringeren Gewichts vom Beschichtungsgas getrennt. Das Beschichtungsgas strömt im oberen Bereich des Behälters radial nach außen und an der Seitenwand 12 des Behälters vertikal nach unten, wobei es die Gehäuseringe 72 passiert und am Boden des Behälters 1 auf das Chromgranulat 51 und den Aktivator trifft, um dann aufgrund der Wirkung der Venturidüse erneut in den Kanal 8 an seiner unteren Öffnung 81 einzutreten.

Mit der vorliegenden Erfindung können sowohl metallische Diffusionsschichten, Auflageschichten mit keiner bis geringer Eindiffusion und keramische CVD-Schichten aufgebracht werden. Beispielsweise kann Zirkon aus Zr(tmhd)₄ verdampft werden und in einen höher temperierten Reaktor an die zu beschichtenden Bauteile geleitet werden. Weiterhin kann Zr aus Zr(tmhd). verdampft werden, mit Argon und O₂-Dotierung in einem Reaktor an die Bauteile geleitet und als ZrO₂ abgeschieden werden. Es kann aber auch Y aus Y(tmhd)₃ verdampft werden und mit Argon und O₂-Dotierung in einem Reaktor an die Bauteile geleitet und als Y₂O₃ abgeschieden werden. Der Vorteil dieser Verfahren ist, dass sie bei niedrigen Prozesstemperaturen ablaufen. Daher ist insbesondere eine mechanische Gasumwälzung leichter zu bewerkstelligen, da keine besonderen Werkstoff-Konstruktionsanforderungen bestehen. Anorganische Verbindungen in Form einer Flüssigkeit verdampfen bei ca. 80°C, wobei das entstehende Gas in den Reaktor strömt und die zu beschichtenden Werkstücke beaufschlagt. Auch dabei ist eine Umwälzung mit Treibgas möglich.

Durch die vorliegende Erfindung wird selbst bei hohen Temperaturen eine gleichmäßige Beschichtung erreicht und ein Schichtgradient auf dem beschichteten Bauteil bzw. Werkstück wird weitgehend vermieden.

Eine gleichmäßige Beschichtungsgaskonzentration wird gewährleistet, ohne dass eine zu starke Verdünnung auftritt und ohne dass aufwendige Konstruktionen, die zudem kostenintensiv und störanfällig sind, notwendig sind. Insbesondere der Einbau einer Venturidüse ist einfach und mit geringen Mitteln zu bewerkstelligen. Eine geringere Verdünnung des Beschichtungsgases wird durch Verwendung von inerten Treibergasen, z.B. Ar, He, Kr, Ne usw. erzielt. Es ist jedoch auch H₂ als Treibgas möglich, wenn die Bildung von HF oder HCI vom Beschichtungsprozeß her erwünscht ist.

Das erfindungsgemäße Gasphasenbeschichtungsverfahren und die erfindungsgemäße Vorrichtung bieten zu dem eine hohe Flexibilität, da bestehende Anlagen leicht nachrüstbar sind und Werkstoffe mit verschiedenen Geometrien beschichtet werden können, ohne dass eine spezielle Ausgestaltung der Vorrichtung oder eine aufwendige Anpassung der Vorrichtung notwendig ist. Selbst Hohlräume und Kanäle im Inneren von Turbinenschaufein können so beschichtet werden, wobei ungleichmäßige Schichtdicken weitgehend vermieden werden.

## Patentansprüche

1. Gasphasenbeschichtungsverfahren, bei dem ein oder mehrere zu beschichtende Werkstücke in einem Behälter angeordnet werden, der Behälter geheizt wird, und ein Spenderstoff mit einem Aktivator durch Aufheizen ein Beschichtungsgas bildet, das im Behälter mit den Werkstücken in Kontakt gebracht und während des Beschichtungsvorgangs zumindest zeitweise im Behälter umgewälzt wird, **dadurch gekennzeichnet, dass** zur Umwälzung ein Treibgas durch eine im Behälter angeordnete Venturidüse in den Behälter geleitet wird.

2. Gasphasenbeschichtungsverfahren nach Anspruch 1, **dadurch gekennzeichnet, dass** als Treibgas ein inertes Gas, wie Ar, He, Kr oder Ne und/oder H₂ verwendet wird.

3. Gasphasenbeschichtungsverfahren nach Anspruch 1 oder 2, **dadurch gekennzeichnet, dass** im Behälter befindliches Treibgas im oberen Bereich des Behälters durch Gravitation vom Beschichtungsgas getrennt und aus dem Behälter abgeführt wird, während das Beschichtungsgas weiterhin im Behälter zirkuliert.

4. Gasphasenbeschichtungsverfahren nach einem oder mehreren der Ansprüche 1 bis 3, **dadurch gekennzeichnet, dass** durch eine Anordnung der Venturidüse im unteren Bereich des Behälters das vom Treibgas umgewälzte Beschichtungsgas vertikal zirkuliert.

5. Gasphasenbeschichtungsverfahren nach einem oder mehreren der vorhergehenden Ansprüche, **dadurch gekennzeichnet, dass** eine keramische Schicht auf die Werkstücke aufgebracht wird, indem Zr und/oder Y außerhalb des Behälters aus einer flüssigen Verbindung verdampft, in den Behälter geführt, mit Gas oxidiert und als Oxid ZrO₂ und/oder Y₂O₃ auf den Werkstücken abgeschieden wird.

6. Vorrichtung zur Gasphasenbeschichtung von Werkstücken, umfassend einen Behälter zur Aufnahme von einem oder mehreren zu beschichtenden Werkstücken,
eine Einrichtung zum Bereitstellen eines Spenderstoffs und eines Aktivators, eine Heizvorrichtung zum Heizen des Behälters und
Mittel zur Umwälzung des Beschichtungsgases im Behälter, so dass beim Beschichten das Beschichtungsgas im Behälter zirkuliert, **dadurch gekennzeichnet, dass** die Mittel zur Umwälzung eine Venturidüse (4) umfassen, die an einem Ende eines von außen zugeführten Treibgasrohres (3) angeordnet ist.

7. Vorrichtung nach Anspruch 6, **dadurch gekennzeichnet, dass** die Venturidüse (4) derart angeordnet ist, dass das vom Treibgas umgewälzte Beschichtungsgas in einem zentralen Bereich des Behälters (1) nach oben strömt, während es im Behälter (1) zirkuliert.

## Claims

1. Gas phase coating process, whereby one or more workpieces to be coated are placed in a container, the container is heated and a donor substance with an activator are heated to generate a coating gas which is brought into contact with the workpieces in the container and circulated in the container for at least some of the time during the coating process, **characterised in that** a propellant gas is introduced into the container via a Venturi nozzle provided in the container for circulation purposes.

2. Gas phase coating process as claimed in claim 1, **characterised in that** an inert gas such as Ar, He, Kr or Ne and/or H₂, is used as the propellant gas.

3. Gas phase coating process as claimed in claim 1 or 2, **characterised in that** in the container, propellant gas in the upper region of the container separates from the coating gas due to gravity and is fed out of the container, whilst the coating gas continues to circulate in the container.

4. Gas phase coating process as claimed in one or more of claims 1 to 3, **characterised in that** the Venturi nozzle is arranged in the bottom region of the container causing the coating gas circulated by the propellant gas to circulate vertically.

5. Gas phase coating process as claimed in one or more of the preceding claims, **characterised in that** a ceramic coating is applied to the workpieces by evaporating Zr and/or Y from a liquid compound outside the container, introducing it into the container, oxidising it with gas and depositing it on the workpieces as an oxide in the form of ZrO₂ and/or Y₂O₃.

6. Device for applying a gas phase coating to workpieces, comprising a container for receiving one or more workpieces to be coated, a system for providing a donor substance and an activator, a heating device for heating the container and
means for circulating the coating gas in the container so that the coating gas is circulated in the container during the coating process,
**characterised in that** the circulating means consist of a Venturi nozzle (4) arranged at one end of a propellant gas pipe (3) feeding in from outside.

7. Device as claimed in claim 6, **characterised in that** the Venturi nozzle (4) is arranged so that the coating gas circulated by the propellant gas flows upwards in a central region of the container (1) as it circulates through the container (1).

## Revendications

1. procédé pour le revêtement par dépôt chimique en phaee vapeur, dans lequel une ou plusieurs pièces à revêtir sont disposées dans un récipient, le récipient est chauffé et une substance dispensatrice avec un activateur formé par chauffage un gaz de revêtement, qui est mis en contact avec les pièces dans le récipient et est mis à circuler dans le récipient, au moins temporairement, pendant le processus de revêtement, **caractérisé en ce que** pour la circulation, on fait passer dans le récipient, un gaz propulseur par une buse à effet Venturi disposée dans le récipient.

2. Procédé pour le revêtement par dépôt chimique en phase vapeur selon la revendication 1, **caractérisé en ce que** comme gaz propulseur, on utilise un gaz inerte comme Ar, He, Kr ou Ne et/ou H₂.

3. Procédé pour le revêtement par dépôt chimique en phase vapeur selon la revendication 1 ou 2, **caractérisé en ce que** le gaz propulseur se trouvant dans le récipient est séparé du gaz de revêtement, dans la partie supérieure du récipient, par gravitation et est extrait du récipient, pendant que le gaz de revêtement continue à circuler dans le récipient.

4. Procédé pour le revêtement par dépôt chimique en phase vapeur selon l'une ou plusieurs des revendications 1 à 3, **caractérisé en ce que** par une disposition de la buse à effet Venturi dans la partie inférieure du récipient, le gaz de revêtement mis en circulation par le gaz propulseur circule verticalement.

5. Procédé pour le revêtement par dépôt chimique en phase vapeur selon l'une ou plusieurs des revendications précédentes, **caractérisé en ce que** l'on applique une couche céramique sur les pièces, **en ce que** Zr et/ou Y est vaporisé à l'extérieur du récipient, à partir d'un composé liquide, est introduit dans le récipient, est oxydé avec un gaz et est déposé sur les pièces sous la forme d'oxyde ZrO₂ et/ou Y₂O₃.

6. Dispositif pour le revêtement de pièces par dépôt chimique en phase vapeur, comprenant un récipient pour la réception d'une ou de plusieurs pièces à revêtir, un arrangement pour préparer une substance dispensatrice et un activateur, un dispositif de chauffage pour chauffer le récipient, et des moyens pour la circulation du gaz de revêtement de sorte que lors du revêtement, le gaz de revêtement circule dans le récipient, **caractérisé en ce que** le moyen pour la circulation comprennent une buae à effet Venturi (4), qui est disposée à une extrémité d'un tube de gaz propulseur (3) amené de l'extérieur.

7. Dispositif selon la revendication 6, **caractérisé en ce que** la buse à effet Venturi (6) est disposée de sorte que le gaz de revêtement déplacé par le gaz propulseur s'écoule vers le haut dans une zone centrale du récipient (1), alors qu'il circule dans le récipient (1).
